# EUROPÄISCHE PATENTSCHRIFT

(11) **EP 3 857 617 B1**
(45) Veröffentlichungstag und Bekanntmachung des Hinweises auf die Patenterteilung: **31.07.2024**
(21) Anmeldenummer: 19778932.4
(22) Anmeldetag: 24.09.2019
(51) Int. Cl.: H01L 31/18, H01L 21/78, H01L 31/05

(54) **VERFAHREN ZUM VEREINZELN EINES HALBLEITERBAUELEMENTES MIT EINEM PN-ÜBERGANG**
METHOD FOR SINGULATING A SEMICONDUCTOR COMPONENT HAVING A PN JUNCTION
PROCÉDÉ DE SÉPARATION D'UN COMPOSANT SEMI-CONDUCTEUR MUNI D'UNE JONCTION PN

(30) Priorität: 24.09.2018 DE 102018123484
(43) Veröffentlichungstag der Anmeldung: 04.08.2021
(73) Patentinhaber: Fraunhofer-Gesellschaft zur Förderung der angewandten Forschung e.V., 80686 München (DE)
(72) Erfinder: LOHMÜLLER, Elmar, 79110 Freiburg (DE); PREU, Ralf, 79110 Freiburg (DE); BALIOZIAN, Puzant, 79110 Freiburg (DE); FELLMETH, Tobias, 79110 Freiburg (DE); WÖHRLE, Nico, 79110 Freiburg (DE); SAINT-CAST, Pierre, 79110 Freiburg (DE); RICHTER, Armin, 79110 Freiburg (DE)
(74) Vertreter: LBP Lemcke, Brommer & Partner Patentanwälte mbB
(86) Internationale Anmeldenummer: PCT/EP2019/075597
(87) Internationale Veröffentlichungsnummer: WO 2020/064669

(56) Entgegenhaltungen:
- EP-A1- 2 546 889
- DE-A1- 102007 041 885
- DE-A1- 102009 026 410
- DE-A1- 4 305 296
- US-A- 4 746 618
- US-A1- 2008 230 116
- US-A1- 2011 073 974
- US-A1- 2017 179 331

## Beschreibung

Die Erfindung betrifft ein Verfahren zum Vereinzeln eines Halbleiterbauelementes mit einem pn-Übergang gemäß Anspruch 1.

Bei der Herstellung von Halbleiterbauelementen ist es häufig wünschenswert, mehrere auf einem Substrat hergestellte Halbleiterbauelemente zu vereinzeln, indem das Substrat an zumindest einer Trennfläche aufgetrennt wird, sodass die Halbleiterbauelemente separiert sind. Ein solches Vereinzeln ist bei der Herstellung von Rechenprozessoren notwendig, da typischerweise eine Vielzahl von Rechenprozessoren auf einem Siliziumwafer hergestellt werden. Darüber hinaus findet ein Vereinzeln von fotovoltaischen Solarzellen zunehmend Anwendung:
Fotovoltaische Module werden heute üblicherweise aus Silizium-Solarzellen mit einer Kantenlänge von ca. 156 mm hergestellt. Die Verschaltung erfolgt durch elektrisch leitende Verbindungen mittels leitenden Elementen - meist sogenannten Zellverbindern -, die jeweils Solarzellen alternierend auf Vorder- und Rückseite verbinden. Ein Nachteil dieser Verschaltung ist, dass der hohe Strom (bis ca. 10 A) der einzelnen Solarzellen eine sehr hohe Leitfähigkeit und somit hohe Leitungsquerschnitte der Zellverbinder voraussetzen.

Eine bekannte Möglichkeit diesen Nachteil zu umgehen ist, auf einem Siliziumwafer zwei oder mehr Solarzellen vorzusehen, um den Strom pro Solarzelle entsprechend proportional zu senken. Diese werden erst zum Ende der Prozessierung vereinzelt, um möglichst lange im Nutzen der großen Ausgangswafer zu produzieren und somit die Produktivität hoch zu halten und etabliertes Produktionsequipment verwenden zu können.

Werden die Solarzellen weiterhin wie oben beschrieben mittels Zellverbinder elektrisch verbunden, so verbleibt zwischen den Solarzellen Raum, der nicht fotovoltaisch aktiv ist und deshalb zu einer Reduktion des Modulwirkungsgrades führt.

Eine bekannte Methode, diesen Nachteil zu umgehen, ist das sogenannte Verschindeln der Solarzellen, bei dem die Oberseite eines Endes einer Solarzelle unmittelbar elektrisch mit der Unterseite der nächsten Zelle verbunden wird. Hierfür werden die externen Kontakte auf der Vorder- und Rückseite an den jeweils gegenüberliegenden Kanten der Solarzellen realisiert. Da üblicherweise zwecks Minimierung der Abschattung keine sehr hoch leitenden Kontaktelemente in der Solarzelle vorhanden sind und für das Schindelkonzept basierend auf großen konventionellen Solarzellen die Strecken, durch die der Strom in den Kontaktfingern zu den außen liegenden externen Kontakten fließen muss, sehr groß werden, werden die Siliziumwafer nach Prozessierung der Solarzellen in schmale Streifen geschnitten, sodass somit mehrere fotovoltaische Solarzellen mit einer typischerweise rechteckigen Form realisiert werden, um beim Verschindeln Leistungsverluste in den Fingernkontakten der Solarzelle zu minimieren.

Die Vereinzelung der auf einem Substrat, insbesondere einem Siliziumwafer hergestellten Halbleiterbauelemente führt zu einer Vergrößerung des Verhältnisses aus Umfang zu Fläche und somit zu einem Ansteigen von flächennormierten Leistungsverlusten durch Randrekombination. Untersuchungen haben gezeigt (J. Dicker, "Analyse und Simulation von hocheffizienten Silizium-Solarzellenstrukturen für industrielle Fertigungstechniken", Dissertation, Universität Konstanz, 2003), dass insbesondere der Bereich, in welchem ein pn-Übergang an eine Trennfläche, an welcher eine Vereinzelung erfolgte, auftrifft, zu Leistungsverlusten führt. Ein Grund hierfür ist insbesondere die Randrekombination in den quasi neutralen Gebieten von Emitter und Basis und wie zuvor beschrieben insbesondere in der Raumladungszone. Hinzu kommt, dass die Trennung der vereinzelten Halbleiterbauelemente an den erzeugten Kanten zu einer deutlichen Erhöhung der Rekombinationsrate selbst führt. Dieser Einfluss ist insbesondere dann relevant, wenn das Halbleiterbauelement an den anderen Oberflächen eine hohe elektronische Güte, insbesondere eine niedrigere Rekombinationsrate durch Passivierungsschichten oder anderen Passivierungsmechanismen aufweist.

Es besteht daher ein Bedarf, Halbleiterbauelemente zu vereinzeln, ohne die elektronische Güte des Halbleiterbauelementes durch die Trennfläche, insbesondere durch Rekombinationseffekte an der Trennfläche, wesentlich zu verringern.

Zur Vermeidung solcher negativen elektronischen Eigenschaften an der Trennfläche ist es bekannt, im Bereich der Trennfläche eine starke Dotierung auszubilden, welche das Halbleitersubstrat vollständig durchdringt und anschließend innerhalb dieser starken Dotierung die Vereinzelung durchzuführen, sodass nach Vereinzelung an den Trennflächen jeweils ein Bereich starker Dotierung ausgebildet ist (W. P. Mulligan, A. Terao, D. D. Smith, P. J. Verlinden, and R. M. Swanson, "Development of chip-size silicon solar cells", in Proceedings of the 28th IEEE Photovoltaic Specialists Conference, Anchorage, USA, 2000, pp. 158-163). Dieses Vorgehen weist den Nachteil auf, dass das Ausbilden der starken Dotierung sehr zeitaufwendig ist und somit für eine industrielle Produktion ungeeignet.

Weiterhin ist bekannt, sogenannte Emitter-Fenster auszubilden (D. König, and G. Ebest, "New contact frame design for minimizing losses due to edge recombination and grid-induced shading", Solar Energy Materials and Solar Cells, vol. 75, no. 3-4, pp. 381-386, 2003). Hierbei wird bei Erzeugen des Emitters durch Maskierungsverfahren und/oder selektives Aufbringen einer Dotierquelle, wie beispielsweise einer Dotierpaste, der Emitter derart ausgebildet, dass der pn-Übergang nicht bis an die Trennfläche angrenzt, sondern ein Abstand von einigen zehn Mikrometern zwischen pn-Übergang und Trennfläche besteht. Zur Ausbildung des Emitterfensters sind jedoch zusätzliche Maskierungsschritte notwendig, sodass ein höherer Zeitaufwand und höherer Kostenaufwand bei der Herstellung entsteht.

Es ist weiterhin bekannt, Isolationsgräben mittels Laserablation, mittels lokal aufgebrachter Ätzpasten durch Drucktechnologie (z.B. Dispensen, Extrusion, Siebdruck, Inkjet) oder alternativer Strukturierungsverfahren in der Zellfläche zu erzeugen, um den Einfluss der hochrekombinativen Bereiche an der Trennfläche auf das Halbleiterbauelement zu minimieren. Die Isolationsgräben sind somit von der Trennfläche beabstandet und trennen einen Randemitterbereich, der für die Funktion des Halbleiterbauelementes nicht mehr zur Verfügung steht, elektrisch von dem innenliegenden Bestandteil des Halbleiterbauelementes. Nachteilig bei diesen Verfahren ist, dass solche Prozesse typischerweise nur im sogenannten Frontend möglich sind und somit in einem Stadium des Herstellungsprozesses, in dem das Halbleiterbauelement, insbesondere die Solarzelle, noch nicht passiviert und metallisiert ist, da zur Passivierung der Isolationsgräben typischerweise Hochtemperaturprozesse notwendig sind (M. D. Abbott, J. E. Cotter, T. Trupke, and R. A. Bardos, "Investigation of edge recombination effects in silicon solar cell structures using photoluminescence", Applied Physics Letters, vol. 88, no. 11, p. 114105, 2006). US 2008/230116 A1 beschreibt ein Verfahren zum Vereinzeln eines Halbleiterelementes mit einem pn-Übergang, nach dem Stand der Technik.

Der vorliegenden Erfindung liegt daher die Aufgabe zugrunde, ein Verfahren zum Vereinzeln eines Halbleiterbauelementes mit einem pn-Übergang sowie ein Halbleiterbauelement mit einem pn-Übergang zur Verfügung zu stellen, sodass ein negativer Einfluss der Trennfläche auf die elektronische Güte verringert wird und die Nachteile der vorbekannten Verfahren vermieden oder zumindest verringert werden.

Gelöst wird diese Aufgabe durch ein Verfahren gemäß Anspruch 1.

Vorteilhafte Ausführungsformen finden sich in den abhängigen Ansprüchen.

Das erfindungsgemäße Verfahren ist bevorzugt zum Herstellen eines erfindungsgemäßen Halbleiterbauelementes, insbesondere einer bevorzugten Ausführungsform hiervon, ausgebildet. Das erfindungsgemäße Halbleiterbauelement ist bevorzugt mittels des erfindungsgemäßen Verfahrens, insbesondere einer bevorzugten Ausführungsform hiervon, ausgebildet.

Das erfindungsgemäße Verfahren zum Vereinzeln eines Halbleiterbauelementes mit einem pn-Übergang weist folgende Verfahrensschritte auf:
In einem Verfahrensschritt A erfolgt ein Bereitstellen eines Halbleiterbauelementes, welches zumindest einen Emitter und zumindest eine Basis mit einem zwischen Emitter und Basis ausgebildeten pn-Übergang und eine nichtmetallische Querleitungsschicht zur Querleitung von Majoritätsladungsträgern des Emitters aufweist, wobei der Emitter die Querleitungsschicht umfasst und/oder die Querleitungsschicht parallel zu dem Emitter und mit diesem elektrisch leitend verbunden ausgebildet ist.

In einem Verfahrensschritt B erfolgt ein Vereinzeln des Halbleiterbauelementes durch Auftrennen in zumindest zwei Teilelemente an zumindest einer Trennfläche.

Wesentlich ist, dass zwischen Verfahrensschritt A und B in einem Verfahrensschritt B0 ein Querleitungsvermeidungsbereich in der Querleitungsschicht ausgebildet wird, um die Querleitungsfähigkeit um zumindest einen Faktor 10 zu verringern und das in Verfahrensschritt B die Trennfläche an den Querleitungsvermeidungsbereich angrenzt und/oder diesen durchdringt.

Die Erfindung ist auf der Erkenntnis begründet, dass die Rekombination in einem Halbleiter generell und somit auch an der Trennfläche proportional vom Produkt zwischen Anzahl von Löchern und Elektronen abhängt und somit die Verringerung der elektronischen Güte des Halbleiterbauelementes wesentlich durch den Transportmechanismus von Elektronen und Löchern zu der Trennfläche begründet ist. Wird nun der Fluss von entweder Elektronen oder Löchern zu der Trennfläche unterbunden oder zumindest erheblich eingeschränkt, wird entsprechend auch eine Verringerung der elektronischen Güte des Halbleiterbauelementes durch die Trennfläche, insbesondere durch Rekombinationsaktivitäten an der Trennfläche, vermieden oder zumindest erheblich verringert. Es wird also der Fluss von Ladungsträgern im Emitter zu der Trennfläche unterbunden oder zumindest erheblich eingeschränkt. Fehlt an der Trennfläche der jeweilige zur Basis komplementäre Rekombinationspartner kommt es nicht zur Rekombination, beziehungsweise die Rekombination wird erheblich verringert.

Bei dem erfindungsgemäßen Verfahren wird nun vor Vereinzeln des Halbleiterbauelementes der Querleitungsvermeidungsbereich ausgebildet, welcher bis an die Trennfläche heranreicht und somit an diese zumindest angrenzt, insbesondere von der Trennfläche durchdrungen wird. Aufgrund der um zumindest einen Faktor 10 verringerten Querleitungsfähigkeit wird durch den Querleitungsvermeidungsbereich wie zuvor beschrieben der negative Einfluss der Trennfläche auf die elektronische Güte vermieden oder zumindest deutlich verringert.

Es ist daher vorteilhaft, mittels des Querleitungsvermeidungsbereichs die Querleitungsfähigkeit um zumindest einen Faktor 10, insbesondere um zumindest einen Faktor 100, zu verringern. Insbesondere ist es vorteilhaft, die Querleitung von Ladungsträgern des Emitters im Querleitungsvermeidungsbereich vollständig zu unterbinden.

Bei einer Vielzahl von Halbleiterbauelementen, insbesondere bei fotovoltaischen Solarzellen mit beispielsweise mittels Diffusion von Dotieratomen oder mittels Implantation hergestellten Emittern, findet eine Querleitung von Ladungsträgern wesentlich im Emitter statt. Typischerweise erfolgt die Querleitung zu metallischen Kontaktierungsstrukturen, welche mit dem Emitter elektrisch leitend zum Zuführen oder (im Falle von fotovoltaischen Solarzellen) Abführen der Majoritätsladungsträger verbunden sind.

Bei einem Emitter des n-Dotierungstyps stellen Elektronen die Majoritätsladungsträger dar und entsprechend bei einem Emitter des p-Dotierungstyps die Löcher.

Ebenso sind Emitterstrukturen bekannt, die keine oder nur eine geringe Querleitungsfähigkeit aufweisen. So ist die Verwendung von sogenannten Hetero-Emittern bekannt, bei welchen zwischen Emitter und Basis eine dünne intrinsische Schicht ausgebildet ist. Insbesondere sind Solarzellenstrukturen bekannt, bei welchen ein Hetero-Emitter mittels einer dotierten Emitterschicht aus amorphem Silizium ausgebildet ist. Solche dotierten Siliziumschichten aus amorphem Silizium weisen eine nur geringe Querleitungsfähigkeit auf, weshalb typischerweise angrenzend an die Emitterschicht eine Schicht mit hoher Querleitungsfähigkeit, das heißt einem geringen Querleitungswiderstand, aufgebracht wird, beispielsweise ein transparentes, leitendes Oxid (TCO, transparent conducting oxide). In diesem Fall erfolgt die Querleitung der Majoritätsladungsträger des Emitters somit im Wesentlichen außerhalb der dotierten Emitterschicht und die zuvor genannte TCO-Schicht stellt die Querleitungsschicht dar.

Bei dem erfindungsgemäßen Verfahren ist wesentlich, wie zuvor beschrieben, die Querleitung der Ladungsträger des Emitters zur Trennfläche zu unterbinden. Entsprechend erfolgt das Ausbilden des Querleitungsvermeidungsbereiches zumindest in der Querleitungsschicht und somit beispielsweise in der zuvor genannten TCO-Schicht bei einem Hetero-Emitter oder in der dotierten Emitterschicht selbst, bei einem diffundierten oder implantierten Emitter, wie zuvor beschrieben.

Das erfindungsgemäße Verfahren weist den Vorteil auf, dass es kostengünstig in den Herstellungsprozess implementiert werden kann und insbesondere die Vereinzelung am Ende des Fertigungsprozesses angewandt werden kann, sodass während des Herstellungsprozesses von einer kostengünstigen großflächigen Bearbeitung des Substrats, insbesondere eines Siliziumwafers, profitiert werden kann.

Bevorzugt erfolgt daher das Durchführen von Verfahrensschritt B0 nach Ausbilden des Emitters und gegebenenfalls einer nichtmetallischen Querleitungsschicht, sofern diese außerhalb des Emitters liegt, wie beispielsweise eine TCO-Schicht, insbesondere bevorzugt vor Ausbilden von Passivierungsschichten. Zusätzlich und/oder alternativ erfolgt bevorzugt das Durchführen von Verfahrensschritt B0 vor Aufbringen einer metallischen Kontaktierungsstruktur, welche mit dem Emitter elektrisch leitend verbunden ist.

Die eingangs genannte Aufgabe ist weiterhin durch ein Halbleiterbauelement gemäß Anspruch 13 gelöst. Das erfindungsgemäße Halbleiterbauelement weist zumindest einen Emitter und zumindest eine Basis auf, wobei zwischen Emitter und Basis ein pn-Übergang ausgebildet ist, sowie zumindest eine nichtmetallische Querleitungsschicht zur Querleitung von Majoritätsladungsträgern des Emitters, wobei der Emitter die Querleitungsschicht umfasst und/oder die Querleitungsschicht parallel zu dem Emitter und mit diesem elektrisch leitend verbunden ausgebildet ist. Das Halbleiterbauelement stellt ein vereinzeltes Halbleiterbauelement dar mit einer Bruchseite, an welcher das Halbleiterbauelement vereinzelt wurde. Wesentlich ist, dass an der Bruchseite ein Querleitungsvermeidungsbereich derart ausgebildet und angeordnet ist, dass die Querleitungsfähigkeit um zumindest einen Faktor 10 verringert ist, wobei der Querleitungsvermeidungsbereich senkrecht zur Bruchseite eine Tiefe im Bereich 5 µm bis 500 µm, insbesondere 10 µm bis 200 µm aufweist.

Hierdurch werden die zuvor bei dem erfindungsgemäßen Verfahren genannten Vorteile erzielt.

Vorteilhafterweise wird der Querleitungsbereich als Trenngraben ausgebildet, durch welchen die Dicke der Querleitungsschicht verringert wird. Hierdurch wird in einfacher Weise eine Verringerung der Querleitungsfähigkeit der Querleitungsschicht und somit einer Erhöhung des Querleitungswiderstandes erzielt, da eine geringere Dicke einen höheren Querleitungswiderstand bewirkt.

Bevorzugt erfolgt eine Verringerung der Dicke der Querleitungsschicht im Querleitungsvermeidungsbereich um zumindest die Hälfte, bevorzugt um zumindest 80 %.

Insbesondere ist es vorteilhaft, dass der Trenngaben den pn-Übergang durchdringend ausgebildet wird. Hierdurch wird zusätzlich ein Angrenzen des pn-Übergangs und somit der Raumladungszone an die Trennfläche vermieden und somit die eingangs genannten negativen Effekte unterbunden.

Vorteilhafterweise weist der Trenngraben eine Tiefe auf, welche zumindest 10%, insbesondere zumindest 20%, bevorzugt zumindest 40% der Dicke des Halbleiterbauelementes beträgt. Hierdurch kann in Verfahrensschritt B in vereinfachter Weise ein Auftrennen erfolgen, insbesondere kann der Trenngraben als Sollbruchstell dienen.

Um ein Auseinanderbrechen im Bereich des Trenngraben in Prozessschritten vor Verfahrensschritt B zu vermeiden, ist es vorteilhaft, wenn die Enden des Trenngrabens jeweils zu den Kanten des Halbleiterbauelementes beabstandet sind, insbesondere einen Abstand im Bereich 0,25 mm bis 20 mm, bevorzugt 0,5 mm bis 5 mm aufweisen. Die Bereiche zwischen den Enden des Trenngrabens und den Kanten des Substrats der Halbleiterbauelemente vor Vereinzelung stabilisieren den Wafer somit vor Verfahrensschritt B. Bevorzugt erfolgt in Verfahrensschritt B vor Vereinzeln des Halbleiterbauelements ein Verlängern des Trenngrabens, so dass die Enden des Trenngrabens einen Abstand kleiner 0,3 mm, insbesondere kleiner 0,1 mm zu den Kanten des Halbleiterbauelementes aufweisen, insbesondere, so dass die Enden des Trenngraben bis an die Kanten des Halbleiterbauelementes heranreichen. Hierdurch wird die stabilisierende Wirkung aufgehoben und die Auftrennung kann vereinfacht erfolgen.

Insbesondere ist es vorteilhaft, dass zwischen Verfahrensschritt B0 und B in einem Verfahrensschritt B1 eine Passivierungsschicht im Trenngraben aufgebracht wird, welche zumindest den an den Trenngraben angrenzenden pn-Übergang überdeckt. Hierdurch wird somit vermieden, dass der pn-Übergang an die Trennfläche angrenzt und hierdurch eine Verringerung der elektronischen Güte des Halbleiterbauelementes erfolgt. Darüber hinaus wird ein negativer Effekt des Angrenzens des pn-Übergangs an die Oberfläche des Trenngrabens vermieden oder zumindest verringert, indem eine Passivierungsschicht aufgebracht wird. Die Passivierungsschicht ist bevorzugt eine dielektrische Schicht, insbesondere bevorzugt eine Schicht mit ortsfesten Ladungen, insbesondere bevorzugt mit einer Flächenladungsdichte im Betrag größer gleich 10¹² cm⁻².

Wie zuvor beschrieben, weisen manche Emitterstrukturen eine nur geringe Querleitungsfähigkeit, das heißt einen hohen Querleitungswiderstand, auf und bei solchen Strukturen ist daher parallel zu dem Emitter die Querleitungsschicht separat zum Emitter ausgebildet, wie beispielsweise die zuvor erwähnte TCO-Schicht als Querleitungsschicht. In diesem Fall liegt die Querleitungsschicht somit außerhalb des Emitters.

In einer vorteilhaften Ausführungsform, in welcher somit die Querleitungsschicht parallel zu dem Emitter angeordnet und separat zu diesem ausgebildet ist, ist es vorteilhaft, dass der Trenngraben die Dicke der Querleitungsschicht verringernd ausgebildet ist, insbesondere, dass der Trenngraben die Querleitungsschicht durchdringend ausgebildet ist.

Der Trenngraben kann in an sich bekannter Weise insbesondere mechanisch und/oder chemisch ausgebildet werden. Vorteilhafterweise wird der Trenngraben mittels Laserablation und/oder mittels lokalem Ätzen (z.B. Ätzpaste aufgebracht mittels Drucktechnologie, nasschemisch oder mittels alternativer ätzenden Medien) ausgebildet.

Insbesondere ist es vorteilhaft, nach Ausbilden des Trenngrabens eine Nachbehandlung durchzuführen, um die Oberflächenrekombination an den Wänden des Trenngrabens, insbesondere in dem Bereich, in welchem der pn-Übergang an den Trenngraben angrenzt, zu verringern. Eine solche Nachbehandlung erfolgt bevorzugt mittels nasschemischem Ätzen.

In einer weiteren vorteilhaften Ausführungsform des erfindungsgemäßen Verfahrens wird im Querleitungsvermeidungsbereich die Materialeigenschaft der Querleitungsschicht zur Verringerung der Querleitungsfähigkeit verändert.

Hierbei wird somit ebenfalls die Querleitung von Ladungsträgern des Emitters zu der Trennfläche vermieden oder zumindest verringert, ohne dass ein Entfernen der Querleitungsschicht im Querleitungsvermeidungsbereich notwendig ist.

Vorteilhafterweise wird im Querleitungsvermeidungsbereich die Kristallstruktur des Materials verändert, insbesondere bevorzugt durch lokale Wärmeeinwirkung, bevorzugt mittels eines Lasers.

Alternativ oder zusätzlich wird bevorzugt im Querleitungsvermeidungsbereich der Emitter mit einem erhöhten Schichtwiderstand ausgebildet, indem der Emitter im Querleitungsvermeidungsbereich eine geringere effektive Dotierkonzentration aufweist. Insbesondere ist es bevorzugt, dass der Emitter im Querleitungsvermeidungsbereich einen um zumindest einen Faktor 10 höheren Schichtwiderstand aufweist.

In einer bevorzugten Ausgestaltung erfolgt eine Erhöhung des Emitterschichtwiderstands im Querleitungsvermeidungsbereich durch eine Gegendiffusion: Im Querleitungsvermeidungsbereich wird eine Gegendiffusion mit einem Dotierstoff eines zu der Emitterdotierung entgegengesetzten Dotierungstyps durchgeführt. Hierdurch verringert sich die effektive Dotierkonzentration im Querleitungsvermeidungsbereich und der Schichtwiderstand erhöht sich entsprechend. Vorteilhafterweise erfolgt die Gegendiffusion nach Ausbilden des Emitters.

Ebenso liegt es im Rahmen der Erfindung, dass mittels der Gegendiffusion der effektive Dotierungstyp des Querleitungsvermeidungsbereichs in den zu dem Dotierungstyp des Emitters entgegengesetzten Dotierungstyp umschlägt. In diesem Fall weist somit der Querleitungsvermeidungsbereich einen zu dem Emitter entgegengesetzten Dotierungstyp auf. Es liegt weiterhin im Rahmen der Erfindung, dass sich der gegendiffundierte Bereich über die Emittertiefe hinaus erststreckt.

Das Vereinzeln des Halbleiterbauelementes in Verfahrensschritt B kann in an sich bekannter Weise erfolgen, insbesondere mittels eines oder mehrerer der nachfolgend beschriebenen Verfahren:
a) Trennen mittels einer Chipsäge (W. P. Mulligan, A. Terao, D. D. Smith, P. J. Verlinden, and R. M. Swanson, "Development of chip-size silicon solar cells", in Proceedings of the 28th IEEE Photovoltaic Specialists Conference, Anchorage, USA, 2000, pp. 158-163);
b) Erzeugen eines Grabens mittels eines Lasers mit nachfolgendem mechanischen Brechen (M. Oswald, M. Turek, J. Schneider, and S. Schönfelder, "Evaluation of silicon solar cell separation techniques for advanced module concepts", in Proceedings of the 28th European Photovoltaic Solar Energy Conference and Exhibition, Paris, France, 2013, pp. 1807-1812);
c) Thermal Laser Separation (TLS): M. Oswald, M. Turek, J. Schneider, and S. Schönfelder, "Evaluation of silicon solar cell separation techniques for advanced module concepts", in Proceedings of the 28th European Photovoltaic Solar Energy Conference and Exhibition, Paris, France, 2013, pp. 1807-1812; S. Eiternick, F. Kaule, H.-U. Zühlke, T. Kießling, M. Grimm, S. Schoenfelder, and M. Turek, "High quality half-cell processing using thermal laser separation", Energy Procedia, vol. 77, pp. 340-345, 2015.
d) Laser induced Cutting (LIC): S. Weinhold, A. Gruner, R. Ebert, J. Schille, and H. Exner, "Study of fast laser induced cutting of silicon materials", in Proc. SPIE 8967, Laser Applications in Microelectronic and Optoelectronic Manufacturing (LAMOM), San Francisco, USA, 2014, 89671J.

Untersuchungen zeigen, dass es insbesondere vorteilhaft ist, das Vereinzeln in Verfahrensschritt B mittels TLS oder LIC auszuführen. Das TLS-Verfahren beruht darauf, dass mittels eines ersten Laserstrahls ein kurzer Lasergraben erzeugt wird, der dann auf Basis von gleichzeitigem Heizen (beispielsweise mittels eines zweiten Laserstrahls) und Kühlen (zum Beispiel mittels eines Luft-Wasser-Gemischs) entlang der zu erzeugenden Kante in beliebiger Richtung mittels eingebrachter thermomechanischer Spannung zu einer Trennung des Wafers führt. Hierdurch ist insbesondere eine Trennfläche unabhängig von der Kristallorientierung des zu trennenden Wafers möglich. Das LIC-Verfahren ist dem TLS-Verfahren recht ähnlich, wobei bei LIC keine aktive Kühlung dem Heizen (beispielsweise durch einen Laserstrahl) nachgeführt wird. Das LIC-Verfahren ist auch unter dem Namen LDC-Verfahren (Laser Direct Cleaving) bekannt.

Weitere vorteilhafte Merkmale und Ausführungsformen der vorliegenden Erfindung werden nachfolgend anhand von Ausführungsbeispielen und den Figuren erläutert. Dabei zeigt:
- Figur 1: fünf Ausführungsbeispiele erfindungsgemäßer Halbleiterbauelemente in Schnittdarstellung;
- Figur 2: eine Draufsicht von oben auf einen Halbleiterwafer zur Verdeutlichung der Position der Trennflächen und
- Figur 3: eine Draufsicht von oben auf einen Halbleiterwafer mit Trenngräben, deren Enden zu den Kanten des Halbleiterbauelementes beabstandet sind.

In den Figuren sind schematische, nicht maßstabsgetreue Darstellungen gezeigt. Insbesondere die Breiten und Dicken der einzelnen Schichten entsprechen zur besseren Darstellbarkeit nicht den tatsächlichen Verhältnissen.

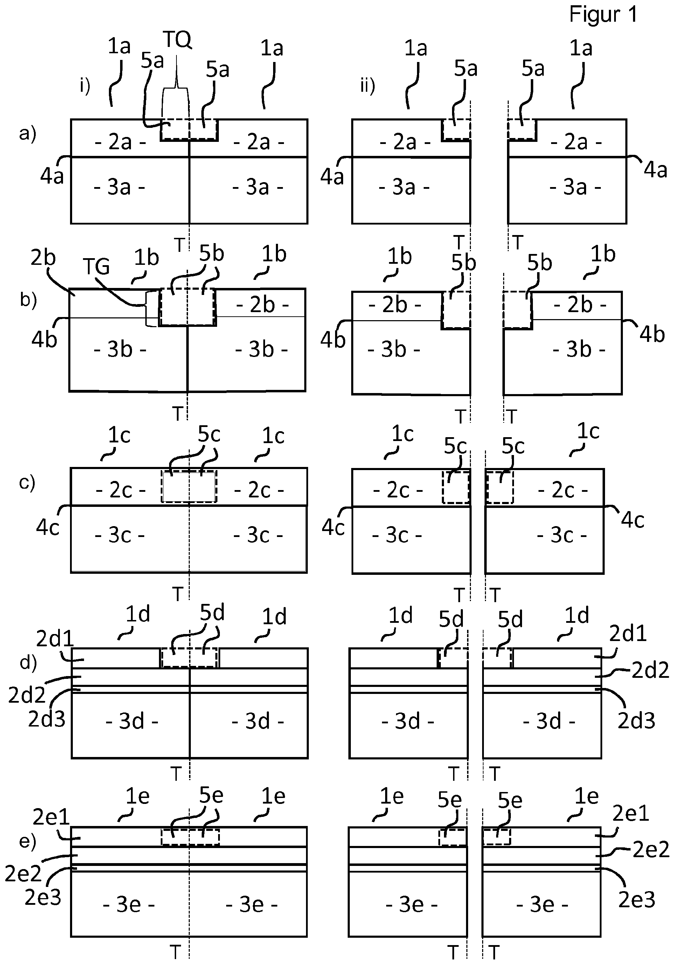

In Figur 1 sind fünf Ausführungsbeispiele a bis e gezeigt. Zu jedem Ausführungsbeispiel ist jeweils in der linken Spalte i) der Zustand vor Vereinzeln und in der rechten Spalte ii) der Zustand nach Vereinzeln dargestellt.

Als Ausführungsbeispiele sind nachfolgend fotovoltaische Solarzellen als Halbleiterbauelemente erläutert. Ebenso können die dargestellten Halbleiterbauelemente in einer Abwandlung der Ausführungsbeispiele als Transistor ausgebildet sein.

Anhand des in Figur 1a) dargestellten ersten Ausführungsbeispiels eines erfindungsgemäßen Halbleiterbauelementes 1a wird nachfolgend ein erstes Ausführungsbeispiel eines erfindungsgemäßen Verfahrens erläutert:
In einem Verfahrensschritt A wird das Halbleiterbauelement 1a bereitgestellt. Dieses weist vorliegend einen mittels Diffusion aus der Gasphase ausgebildeten Emitter 2a des n-Dotierungstyps und entsprechend eine Basis 3a auf, welche mit einem Dotierstoff des p-Dotierungstyps dotiert ist. Entsprechend bildet sich zwischen Emitter 2a und Basis 3a ein pn-Übergang 4a aus. Emitter und Basis wurden in einem Siliziumwafer ausgebildet. In einer Abwandlung des Ausführungsbeispiels wird der Emitter mittels Diffusion aus einer vorab aufgebrachten Dotierschicht oder mittels Implantation ausgebildet. Ebenso können die Dotiertypen von Emitter und Basis vertauscht sein.

In einem Verfahrensschritt B0 erfolgt das Ausbilden eines Querleitungsvermeidungsbereiches 5a in der Querleitungsschicht, das heißt vorliegend im Emitter 2a. Der Querleitungsvermeidungsbereich grenzt an eine Trennfläche T an, an welcher nachfolgend eine Vereinzelung erfolgen soll. Der Querleitungsvermeidungsbereich ist senkrecht zur Bruchseite und somit senkrecht zu Trennfläche T mit einer Tiefe TQ im Bereich 5 µm bis 500 µm, vorliegend 100 µm ausgebildet.

Wie in Figur 1a, i ersichtlich, werden beidseitig der Trennfläche T symmetrisch zwei Querleitungsvermeidungsbereiche 5a ausgebildet, welche in diesem Zustand einen gemeinsamen Querleitungsvermeidungsbereich ausbilden, der nach Auftrennen entsprechend in zwei Querleitungsvermeidungsbereiche 5a aufgetrennt wird. Vorliegend ist der Querleitungsvermeidungsbereich 5a als Trenngraben ausgebildet, in dem mittels Laserablation die Dicke des Emitters 2a um 80 % verringert wurde. Hierdurch wurde eine Erhöhung des Querleitungswiderstandes des Emitters um einen Faktor 100 im Bereich des Querleitungsvermeidungsbereiches, das heißt im Bereich des abgedünnten Emitters, erzielt und somit eine Verringerung der Querleitungsfähigkeit um einen Faktor 100.

Anschließend werden zusätzliche, an sich bekannte Komponenten einer Solarzelle erzeugt: Dies umfasst Passivierungsschichten an der oben liegenden Vorderseite sowie an der unten liegenden Rückseite, Metallisierungsstrukturen an Vorder- und Rückseite zum Abführen von Ladungsträgern sowie Antireflexschichten an der Vorder- und gegebenenfalls Rückseite zum Erhöhen der Lichtabsorption. Diese Komponenten sind zur besseren Übersichtlichkeit nicht dargestellt.

In diesem Ausführungsbeispiel erfolgt somit eine Querleitung von Majoritätsladungsträgern in Emitter 2a zu den vorderseitigen metallischen Kontaktierungsstrukturen (nicht dargestellt). Der Emitter 2a stellt in diesem Fall somit ebenso die Querleitungsschicht dar.

Anschließend wird in einem Verfahrensschritt B mittels des vorbeschriebenen TLS-Verfahrens ein Auftrennen an der Trennfläche T durchgeführt. Die Trennfläche T steht senkrecht zur Zeichenfläche in Figur 1 und durchdringt somit Basis 3a sowie Emitter 2a.

Das TLS-Verfahren wird ausgehend von der Rückseite durchgeführt, das heißt zunächst wird mittels eines Lasers ein Initialgraben an der unten liegenden Rückseite in dem Bereich, in welchem die Trennlinie T die Rückseite schneidet, ausgebildet. Der Initialgraben beginnt an einer Kante des Halbleiterbauelementes. Der Initialgraben erstreckt sich nicht über die gesamte Breite des Halbleiterbauelementes. Typische Initialgräben weisen eine Länge im Bereich 200 µm bis 4 mm auf, typischerweise kleiner 2 mm. Anschließend erfolgt wie zuvor beschrieben mittels gleichzeitigem Heizen und Kühlen ein Auftrennen des Halbleiterbauelementes.

Das Ergebnis ist in Figur 1a, ii dargestellt: Es werden somit zwei spiegelbildlich symmetrische Halbleiterbauelemente erzeugt, die jeweils einen Querleitungsvermeidungsbereich 5a aufweisen, welcher an die Trennfläche T angrenzt.

Zur Vermeidung von Wiederholungen wird bei Erläuterung der Figuren 1b bis 1e lediglich auf die wesentlichen Unterschiede eingegangen:
In Figur 1b ist als zweites Ausführungsbeispiel eines erfindungsgemäßen Verfahrens eine Abwandlung des Verfahrens gemäß Figur 1a dargestellt, bei welchem der als Trenngraben ausgebildete Querleitungsvermeidungsbereich 5b den pn-Übergang 4b zwischen Emitter 2b und Basis 3b vollständig durchdringt.

Zwischen Verfahrensschritt B0 und Verfahrensschritt B wird daher, das heißt vor Vereinzeln, ein Ätzvorgang durchgeführt, um eine eventuelle Schädigung an den Wänden des Trenngrabens zu vermeiden. Weiterhin wird mittels thermischer Oxidation an den Wänden des Trenngrabens eine Siliziumoxidschicht aufgebracht, welche somit auch den pn-Übergang 4b in dem Bereich, in welchem dieser an den Querleitungsvermeidungsbereich angrenzt, überdeckt. Hierdurch wird die elektronische Güte weiter erhöht. Der Trenngraben weist eine Tiefe TG von mehreren 100 nm bis 50 µm auf, vorliegend 20 µm, welche somit bei einer Dicke von 200 µm des Halbleiterbauelementes 10% der Dicke entspricht.

Das Ergebnis nach Auftrennen an der Trennfläche T in Verfahrensschritt B ist in Figur 1b, ii dargestellt. Auch hier ergeben sich somit zwei spiegelbildliche Halbleiterbauelemente 1b.

In einem dritten Ausführungsbeispiel des erfindungsgemäßen Verfahrens gemäß Figur 1c erfolgt eine Abwandlung derart, dass der Querleitungsvermeidungsbereich 5c im Emitter 2c nicht als Trenngraben, sondern als Bereich verringerter Emitterdotierung ausgebildet ist. Dies wird erzielt, indem im Querleitungsvermeidungsbereich 5c eine Gegendiffusion erfolgt: Wie auch bei den vorangehenden Ausführungsbeispielen ist der Emitter 2c n-dotiert und die Basis 3c p-dotiert. Durch Einbringen von Boratomen mittels lokaler Diffusion (mittels Erwärmen, insbesondere lokalem Erwärmen, bevorzugt mittels eines Laser) aus einem den Dotierstoff enthaltenden Dotiermedium, insbesondere einer Dotierpaste, in den Querleitungsvermeidungsbereich 5c erfolgt eine Verringerung der effektiven Dotierkonzentration des Emitters im Querleitungsvermeidungsbereich 5c, sodass entsprechend eine Erhöhung des Schichtwiderstands des Emitters und somit eine Erhöhung des Querleitungswiderstands des Emitters um einen Faktor 100 erzielt wird.

Nach Vereinzeln in Verfahrensschritt B (Darstellung Figur 1c, ii) ist somit der Stromfluss von Ladungsträgern im Emitter 2c zu der Trennfläche T aufgrund des erhöhten Emitterschichtwiderstandes im Querleitungsvermeidungsbereich 5c verringert.

In den Figuren 1d und e wird ein viertes und ein fünftes Ausführungsbeispiel gezeigt, bei welchem der Emitter als Hetero-Emitter ausgebildet ist:
In einem Siliziumwafer ist eine Basis 3d, 3e ausgebildet, welche vorliegend n-dotiert ist. An der Vorderseite ist ein Schichtsystem aufgebracht, welches - ausgehend von der Basis 3d, 3e - eine intrinsische Siliziumschicht (i-Si-Schicht) 2d3, 2e3, eine amorphe Siliziumschicht (a-Si-Schicht) 2d2, 2e2 sowie eine transparente Oxidschicht (TCO-Schicht) 2d1, 2e1 aufweist.

Der Emitter wird somit als Hetero-Emitter durch die a-Si-Schicht und die i-Si-Schicht ausgebildet. Die a-Si-Schicht (2d2, 2e2) weist nur eine geringe Querleitungsfähigkeit, das heißt einen hohen Querleitungswiderstand, auf. Um Majoritätsladungsträger mittels Querleitungen abführen zu können, ist daher an der Vorderseite der a-Si-Schicht 2d2, 2e2 die TCO-Schicht 2d1, 2e1 angeordnet. In diesen beiden Ausführungsbeispielen stellt somit die TCO-Schicht die Querleitungsschicht dar.

Entsprechend wird in der TCO-Schicht 2d1, 2e1 in Verfahrensschritt B0 ein Querleitungsvermeidungsbereich 5d, 5e ausgebildet.

In dem vierten Ausführungsbeispiel gemäß Figur 1d ist der Querleitungsvermeidungsbereich 5d als Trenngraben ausgebildet, in dem mittels Laserablation die TCO-Schicht 2d1 im Querleitungsvermeidungsbereich 5d vollständig entfernt wurde. Wie in Figur 1d, ii ersichtlich, grenzt nach Vereinzeln der Emitter mit a-Si-Schicht 2d2 und i-Si-Schicht 2d3 zwar unverändert an die Trennfläche T an, die TCO-Schicht 2d1 ist jedoch zu der Trennfläche T beabstandet. Aufgrund der zuvor erläuterten geringen Querleitungsfähigkeit der a-Si-Schicht 2d2 ist auch in diesem Fall somit die Querleitung von Ladungsträgern des Emitters zu der Trennfläche erheblich verringert.

Bei dem fünften Ausführungsbeispiel gemäß Figur 1e erfolgt die Ausbildung des Querleitungsvermeidungsbereiches 5e derart, dass mittels Wärmeeinwirkung die Struktur des TCO verändert wird, in eine Form deutlich reduzierter elektrischer Leitfähigkeit, insbesondere die kristalline Struktur in eine teilamorphe oder amorphe Struktur überführt. Auch ohne Änderung der Dicke der TCO-Schicht 2e1 im Querleitungsvermeidungsbereich 5e wird auf diese Weise der Querleitungswiderstand der TCO-Schicht im Querleitungsvermeidungsbereich 5e um einen Faktor 100 erhöht.

In Figur 1 ist aus Gründen der besseren Darstellbarkeit jeweils lediglich eine Trennfläche dargestellt.

Bei dem Vereinzeln von fotovoltaischen Solarzellen beispielsweise zur Ausbildung von Modulen gemäß der eingangs genannten Schindelungstechnik erfolgt üblicherweise ausgehend von einem Siliziumwafer ein Vereinzeln einer Mehrzahl von Solarzellen.

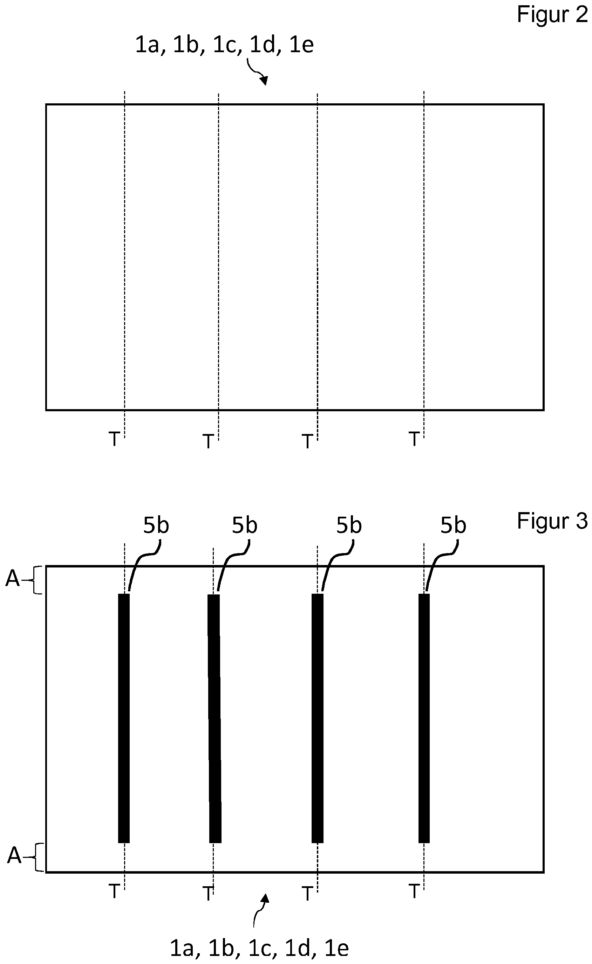

In Figur 2 ist eine schematische Draufsicht von oben auf einen Siliziumwafer, in welchem fotovoltaische Solarzellen ausgebildet wurden, dargestellt. An mehreren, vorliegend vier, Trennflächen T erfolgt ein Durchführen eines der vorbeschriebenen Verfahren, sodass nach Vereinzeln fünf Halbleiterbauelemente vorliegen.

In Figur 3 ist eine weitere schematische Draufsicht von oben auf einen Siliziumwafer, in welchem fotovoltaische Solarzellen ausgebildet wurden, dargestellt, zur Verdeutlichung des Ausführungsbeispiels gemäß Figur 1b). Die als Trenngräben ausgebildeten Querleitungsvermeidungsbereiche 5b sind zu den Kanten des Halbleiterbauelementes beabstandet, mit einem Abstand A von 1 mm. Dies führt zu einer Stabilisierung des Halbleiterwafers, trotz dessen, dass die Trenngräben eine Tiefe TG von 30% der Dicke des Halbleiterbauelementes aufweisen. Vor Vereinzeln der Halbleiterbauelemente werden die Trenngräben bis zu den Kanten weitergebildet, so dass die Enden der Trenngräben an den Kanten liegen, der Abstand A somit 0 ist. Anschließend kann vereinfacht die Vereinzelung erfolgen, mit einem geringeren Fehlerrisiko, da die zuvor beschriebene Stabilisierung durch Weiterführen der Trenngräben aufgehoben wurde.

### Bezugszeichenliste

- 1a, 1b, 1c, 1d, 1e: Halbeiterbauelement
- 2a, 2b, 2c: Emitter
- 2d1, 2e1: TCO-Schicht
- 2d2, 2e2: a-Si-Schicht
- 2d3, 2e3: i-Si-Schicht
- 3a, 3b, 3c, 3d, 3e: Basis
- 4a, 4b, 4c: pn-Übergang
- 5a, 5b, 5c, 5d, 5e: Querleitungsvermeidungsbereich
- T: Trennfläche
- TQ: Tiefe Querleitungsvermeidungsbereich
- TG: Tiefe Trenngraben
- A: Abstand zu Kante

## Patentansprüche

1. Verfahren zum Vereinzeln eines Halbleiterbauelementes (1a, 1b, 1c, 1d, 1e) mit einem pn-Übergang (4a, 4b, 4c), mit den Verfahrensschritten
A. Bereitstellen eines Halbleiterbauelementes (1a, 1b, 1c, 1d, 1e), welches zumindest einen Emitter (2a, 2b, 2c) und zumindest eine Basis (3a, 3b, 3c, 3d, 3e) mit einem zwischen Emitter (2a, 2b, 2c) und Basis (3a, 3b, 3c, 3d, 3e) ausgebildeten pn-Übergang (4a, 4b, 4c) und eine nichtmetallische Querleitungsschicht zur Querleitung von Majoritätsladungsträgern des Emitters (2a, 2b, 2c) aufweist, wobei der Emitter (2a, 2b, 2c) die Querleitungsschicht umfasst und/oder die Querleitungsschicht parallel zu dem Emitter (2a, 2b, 2c) und mit diesem elektrisch leitend verbunden ausgebildet ist,
B. Vereinzeln des Halbleiterbauelementes (1a, 1b, 1c, 1d, 1e) durch Auftrennen in zumindest zwei Teilelemente an zumindest einer Trennfläche (T),
dass zwischen Verfahrensschritt A und B in einem Verfahrensschritt B0 ein Querleitungsvermeidungsbereich (5a, 5b, 5c, 5d, 5e) in der Querleitungsschicht ausgebildet wird, um die Querleitungsfähigkeit um zumindest einen Faktor 10 zu verringern und dass in Verfahrensschritt B die Trennfläche (T) an den Querleitungsvermeidungsbereich (5a, 5b, 5c, 5d, 5e) angrenzt und/oder diesen durchdringt,
**dadurch gekennzeichnet,**
**dass** der Querleitungsvermeidungsbereich (5a, 5b, 5c, 5d, 5e) als Trenngraben ausgebildet ist, wobei der Trenngraben die Querleitungsschicht vollständig durchdringt,
**dass** der Trenngraben den pn-Übergang (4a, 4b, 4c) durchdringend ausgebildet wird,
**dass** zwischen Verfahrensschritt B0 und B in einem Verfahrensschritt B1 eine Passivierungsschicht im Trenngraben aufgebracht wird, welche zumindest den an den Trenngraben angrenzenden pn-Übergang (4a, 4b, 4c) überdeckt,
**dass** in Verfahrensschritt B das Vereinzeln mittels thermischem Laserseparieren (TLS, LIC oder LDC) erfolgt und
**dass** Verfahrensschritt B0 vor Aufbringen einer oder mehrerer metallischer Kontaktierungsstrukturen durchgeführt wird.

2. Verfahren nach Anspruch 1,
**dadurch gekennzeichnet,**
**dass** der Trenngraben eine Tiefe (TG) aufweist, welche zumindest 10%, insbesondere zumindest 20%, bevorzugt zumindest 40% der Dicke des Halbleiterbauelementes beträgt.

3. Verfahren nach einem der vorangegangenen Ansprüche,
**dadurch gekennzeichnet,**
**dass** die Querleitungsschicht (2d1, 2e1) parallel und separat zu dem Emitter (2a, 2b, 2c) angeordnet ausgebildet ist.

4. Verfahren nach einem der vorangegangenen Ansprüche,
**dadurch gekennzeichnet,**
**dass** der Trenngraben mittels Laserablation und/oder mittels lokalem Ätzen ausgebildet wird.

5. Verfahren nach einem der vorangegangenen Ansprüche,
**dadurch gekennzeichnet,**
**dass** der Trenngraben zu den Kanten des Halbleiterbauelementes beabstandet ausgebildet wird, insbesondere mit einem Abstand im Bereich 0,25 mm bis 20 mm, bevorzugt 0,5 mm bis 5 mm, bevorzugt,
**dass** in Verfahrensschritt B vor Vereinzeln des Halbleiterbauelements ein Verlängern des Trenngrabens erfolgt, so dass die Enden des Trenngrabens einen Abstand kleiner 0,3 mm, insbesondere kleiner 0,1 mm zu den Kanten des Halbleiterbauelementes aufweisen, insbesondere, so dass die Enden des Trenngraben bis an die Kanten des Halbleiterbauelementes heranreichen.

6. Verfahren nach einem der vorangegangenen Ansprüche,
**dadurch gekennzeichnet,**
**dass** im Querleitungsvermeidungsbereich (5a, 5b, 5c, 5d, 5e) die Materialeigenschaft der Querleitungsschicht zur Verringerung der Querleitungsfähigkeit verändert wird.

7. Verfahren nach Anspruch 6,
**dadurch gekennzeichnet,**
**dass** im Querleitungsvermeidungsbereich (5a, 5b, 5c, 5d, 5e) die Kristallstruktur des Materials verändert wird, insbesondere in eine Form reduzierter elektrischer Leitfähigkeit, bevorzugt von einem kristallinen in einen teilamorphen oder amorphen Zustand, insbesondere durch lokale Wärmeeinwirkung, bevorzugt mittels eines Lasers oder eines Teilchenstrahls.

8. Verfahren nach einem der Ansprüche 6 bis 7,
**dadurch gekennzeichnet,**
**dass** im Querleitungsvermeidungsbereich (5a, 5b, 5c, 5d, 5e) der Schichtwiderstand des Emitters um zumindest einen Faktor 10 erhöht wird, bevorzugt durch Gegendiffusion.

9. Verfahren nach einem der vorangegangenen Ansprüche,
**dadurch gekennzeichnet,**
**dass** Verfahrensschritt B0 nach Ausbilden des Emitters durchgeführt wird, insbesondere, dass Verfahrensschritt B0 vor Ausbilden von Passivierungsschichten durchgeführt wird.

## Claims

1. Method for singulating a semiconductor component (1a, 1b, 1c, 1d, 1e) having a pn junction (4a, 4b, 4c), comprising the following method steps
A. providing a semiconductor component (1a, 1b, 1c, 1d, 1e) which has at least one emitter (2a, 2b, 2c) and at least one base (3a, 3b, 3c, 3d, 3e), with a pn junction (4a, 4b, 4c) formed between the emitter (2a, 2b, 2c) and the base (3a, 3b, 3c, 3d, 3e), and has a non-metallic transverse-conduction layer for transverse-conductance of majority charge carriers of the emitter (2a, 2b, 2c), the emitter (2a, 2b, 2c) comprising the transverse-conduction layer and/or the transverse-conduction layer being formed in parallel with the emitter (2a, 2b, 2c) and being electrically conductively connected thereto,
B. singulating the semiconductor component (1a, 1b, 1c, 1d, 1e) by separating it into at least two sub-components on at least one separating surface (T),
in that between method steps A and B, in a method step B0, a transverse-conduction avoidance region (5a, 5b, 5c, 5d, 5e) is formed in the transverse-conduction layer in order to reduce the transverse-conduction capability by at least a factor of 10 and in that in method step B, the separating surface (T) adjoins and/or penetrates the transverse-conduction avoidance region (5a, 5b, 5c, 5d, 5e),
**characterised**
**in that** the transverse-conduction avoidance region (5a, 5b, 5c, 5d, 5e) is designed as a separating trench, the separating trench completely penetrating the transverse-conduction layer,
**in that** the separation trench is formed so as to penetrate the pn junction (4a, 4b, 4c),
**in that** between method steps B0 and B, in a method step B1, a passivation layer is applied in the separation trench, which covers at least the pn junction (4a, 4b, 4c) adjoining the separation trench,
**in that** in method step B the singulation is carried out by means of thermal laser separation (TLS, LIC or LDC) and
**in that** method step B0 is carried out before applying one or a plurality of metal contact structures.

2. Method according to claim 1,
**characterised**
**in that** the separation trench has a depth (TG) which is at least 10%, in particular at least 20%, preferably at least 40% of the thickness of the semiconductor component.

3. Method according to any of the preceding claims,
**characterised**
**in that** the transverse-conduction layer (2d1, 2e1) is arranged in parallel with and separately from the emitter (2a, 2b, 2c).

4. Method according to any of the preceding claims,
**characterised**
**in that** the separation trench is formed by means of laser ablation and/or by means of local etching.

5. Method according to any of the preceding claims,
**characterised**
**in that** the separation trench is formed so as to be spaced apart from the edges of the semiconductor component, in particular at a distance in the range 0.25 mm to 20 mm, preferably 0.5 mm to 5 mm, preferably,
**in that** in method step B, before singulating the semiconductor component, the separation trench is extended so that the ends of the separation trench are at a distance of less than 0.3 mm, in particular less than 0.1 mm, from the edges of the semiconductor component, in particular so that the ends of the separation trench touch the edges of the semiconductor component.

6. Method according to any of the preceding claims,
**characterised**
**in that** in the transverse-conduction avoidance region (5a, 5b, 5c, 5d, 5e), the material property of the transverse-conduction layer is changed to reduce the transverse-conduction capability.

7. Method according to claim 6,
**characterised**
**in that** in the transverse-conduction avoidance region (5a, 5b, 5c, 5d, 5e), the crystal structure of the material is changed, in particular into a form having reduced electrical conductivity, preferably from a crystalline into a partially amorphous or amorphous state, in particular by local thermal action, preferably by means of a laser or a particle beam.

8. Method according to any of claims 6 to 7,
**characterised**
**in that** in the transverse-conduction avoidance region (5a, 5b, 5c, 5d, 5e), the layer resistance of the emitter is increased by at least a factor of 10, preferably by counter-diffusion.

9. Method according to any of the preceding claims,
**characterised**
**in that** method step B0 is carried out after formation of the emitter, in particular **in that** method step B0 is carried out before formation of passivation layers.

## Revendications

1. Procédé pour séparer un composant semi-conducteur (1a, 1b, 1c, 1d, 1e) avec une jonction pn (4a, 4b, 4c), comprenant les étapes de procédé
A. préparer un composant semi-conducteur (1a, 1b, 1c, 1d, 1e) qui comporte au moins un émetteur (2a, 2b, 2c) et au moins une base (3a, 3b, 3c, 3d, 3e) avec une jonction pn (4a, 4b, 4c) formée entre émetteur (2a, 2b, 2c) et base (3a, 3b, 3c, 3d, 3e) et une couche de conduction transversale non métallique pour la conduction transversale de porteurs de charge majoritaires de l'émetteur (2a, 2b, 2c), dans lequel l'émetteur (2a, 2b, 2c) comprend la couche de conduction transversale et/ou la couche de conduction transversale est formée parallèlement à l'émetteur (2a, 2b, 2c) et reliée à celui-ci de manière électriquement conductrice,
B. séparer le composant semi-conducteur (1a, 1b, 1c, 1d, 1e) par division en au moins deux éléments partiels en au moins une surface de division (T),
qu'entre les étapes de procédé A et B, en une étape de procédé B0, une zone d'évitement de conduction transversale (5a, 5b, 5c, 5d, 5e) est formée dans la couche de liaison transversale pour réduire d'au moins un facteur 10 la capacité de conduction transversale, et qu'à l'étape de procédé B, la surface de division (T) est limitrophe de la zone d'évitement de conduction transversale (5a, 5b, 5c, 5d, 5e) et/ou traverse celle-ci,
**caractérisé en ce que**
la zone d'évitement de conduction transversale (5a, 5b, 5c, 5d, 5e) est conformée en une tranchée de division, dans lequel la tranchée de division traverse complètement la couche de conduction transversale,
la tranchée de division est formée en traversant la jonction pn (4a, 4b, 4c),
entre les étapes de procédé B0 et B, en une étape de procédé B1, une couche de passivation est appliquée dans la tranchée de division, qui couvre au moins la j onction pn (4a, 4b, 4c) limitrophe de la tranchée de division,
à l'étape de procédé B, la séparation se fait par séparation laser (TLS, LIC ou LDC) et l'étape B0 est réalisée avant l'application d'une ou plusieurs structures de contact métalliques.

2. Procédé selon la revendication 1,
**caractérisé en ce que**
la tranchée de division présente une profondeur (TG) qui représente au moins 10 % de l'épaisseur du composant semi-conducteur, en particulier au moins 20 %, de préférence au moins 40 %.

3. Procédé selon l'une des revendications précédentes,
**caractérisé en ce que**
la couche de conduction transversale (2d1, 2e1) est formée parallèlement à l'émetteur (2a, 2b, 2c) et séparément de celui-ci.

4. Procédé selon l'une des revendications précédentes,
**caractérisé en ce que**
la tranchée de division est formée par ablation laser et/ou gravure locale.

5. Procédé selon l'une des revendications précédentes,
**caractérisé en ce que**
la tranchée de division est formée de manière écartée des bords du composant semi-conducteur, en particulier avec un écart dans la plage 0,25 mm à 20 mm, de préférence 0,5 mm à 5 mm, de préférence,
à l'étape de procédé B, avant la séparation du composant semi-conducteur, a lieu un allongement de la tranchée de division, de telle sorte que les extrémités de la tranchée de division présentent un écart inférieur à 0,3 mm, en particulier inférieur à 0,1 mm, par rapport aux bords du composant semi-conducteur, en particulier de telle sorte que les extrémités de la tranchée de division s'étendent jusqu'aux bords du composant semi-conducteur.

6. Procédé selon l'une des revendications précédentes,
**caractérisé en ce que**
dans la zone d'évitement de liaison transversale (5a, 5b, 5c, 5d, 5e), la propriété de matériau de la couche de conduction transversale est modifiée pour réduire la capacité de conduction transversale.

7. Procédé selon la revendication 1,
**caractérisé en ce que**
dans la zone d'évitement de liaison transversale (5a, 5b, 5c, 5d, 5e), la structure cristalline du matériau est modifiée, en particulier en une forme à conductivité électrique réduite, de préférence d'un état cristallin à un état partiellement amorphe ou amorphe, en particulier par action thermique locale, en particulier à l'aide d'un laser ou d'un faisceau de particules.

8. Procédé selon l'une des revendications 6 à 7,
**caractérisé en ce que**
dans la zone d'évitement de conduction transversale (5a, 5b, 5c, 5d, 5e), la résistance à couche de l'émetteur est accrue d'au moins un facteur 10, de préférence par contre-diffusion.

9. Procédé selon l'une des revendications précédentes,
**caractérisé en ce que**
l'étape de procédé B0 est réalisée après la formation de l'émetteur, en particulier l'étape de procédé B0 est réalisée avant la formation de couches de passivation.
